# EUROPEAN PATENT SPECIFICATION

(11) **EP 3 582 261 B1**
(45) Date of publication and mention of the grant of the patent: **15.11.2023**
(21) Application number: 17904279.1
(22) Date of filing: 21.06.2017
(51) Int. Cl.: G09F 9/33, H01L 25/075, H01L 33/62, H01L 33/48, H01L 33/56

(54) **METHOD FOR PREPARING A SURFACE-MOUNTED RGB-LED PACKAGING MODULE**
VERFAHREN ZUR HERSTELLUNG EINES OBERFLÄCHENMONTIERTEN RGB-LED-VERPACKUNGSMODULS
PROCÉDÉ DE FABRICATION D'UN MODULE D'ENCAPSULATION DE DEL-RGB MONTÉ EN SURFACE

(30) Priority: 28.03.2017 CN 201710194308
(43) Date of publication of application: 18.12.2019
(73) Proprietor: Shandong Prosperous Star Optoelectronics Co., Ltd, Tai'an, Shandong 271200 (CN)
(72) Inventor: LI, Shaoli, Tai'an Shandong 271200 (CN); KONG, Yiping, Tai'an Shandong 271200 (CN); YUAN, Xincheng, Tai'an Shandong 271200 (CN)
(74) Representative: Cabinet Chaillot
(86) International application number: PCT/CN2017/089336
(87) International publication number: WO 2018/176657

(56) References cited:
- CN-A- 103 177 662
- CN-A- 103 594 464
- CN-A- 106 531 730
- CN-A- 106 847 801
- CN-B- 102 945 845
- CN-U- 204 289 443
- CN-U- 205 264 271
- JP-A- 2005 347 401
- JP-A- 2009 099 926

## Description

### Technical Field

The present invention relates to an SMD LED packaging technology, and more particularly relates to a method for preparing a surface-mounted RGB LED packaging module.

### Background Art

With continuous development of the display screen industry, LEDs for display screens are rapidly transformed from original DIP (dual inline-pin package) structures to SMD (Surface Mounted Devices) structures. The LEDs of the SMD structures have been increasingly accepted by users due to the advantages of light weight, smaller size, automatic installation, large illumination angle, uniform color, little attenuation and the like. Although the general SMD LEDs have the above advantages, problems of large attenuation, long heat conduction path, low carrying current, complicated production, low reliability, low moisture resistance, poor weather resistance and the like still exist. If the reliability of a product is to be improved without changing the overall structure of the product, there is still no good solution in the industry.

In the conventional SMD LED preparing, the products are generally of PLCC4 structures (e.g., 3528, 2121, 1010, and other specifications). However, these structures exist individually at present. When customers use the products, the production efficiency is low, the products can only be mounted one by one, and the maintenance difficulty is high. When small-sized products are produced, e.g., when the products having the specifications of 1.0 mm * 1.0 mm or less are produced, the production difficulty of the products is multiplied, the mechanical strength of the products is very low, the products are easily damaged by external force, the production efficiency is also very low, and the requirements for mounting equipment are high. For the single-mount problem, the production efficiency is improved to certain extent by using a COB (chip on board) integrated module. However, the COB integrated module also causes many problems, such as color development difference and poor entire screen consistency caused by center value differences of different batches of chips or substrate ink differences. On the other hand, the chip directly mounted on the circuit board is not well protected such that the reliability cannot be guaranteed, and the failure maintenance cost of the light emitting unit is high. Due to the problems of color development difference and poor entire screen consistency caused by center value differences of different batches of chips or substrate ink differences, high failure maintenance cost of the light emitting unit and the like, the prior art has yet to be improved and developed.

JP 2009 099926 A discloses a base provided with a hole for accommodating a light emitting unit, a wiring conductor provided at a bottom of the hole and electrically connected to the light emitting unit, and separated from each other in a circumferential direction of an opening of the hole. In addition, a plurality of metal layers is provided on the inner wall of the hole.

CN 204 289 443 U and JP 2005 347401 A also illustrate the technological background of surface-mounted RGB-LED packaging modules obtained by a method according to the invention.

### Summary of the Invention

The present invention is directed to provide a method for preparing a surface-mounted RGB LED packaging module, aiming at solving the problems of low production efficiency, high production difficulty, low product mechanical strength and the like of the existing mounted RGB LED products.

To solve the above problems, the technical scheme of the present invention is as follows:
A method for preparing a surface-mounted RGB LED packaging module, comprising the following steps:
step 1: cladding two sides of a plate with copper to form a substrate, drilling holes through the substrate, and forming multiple groups of metal vias penetrating up and down the substrate to electrically connect the front and reverse sides of the substrate;
step 2: etching multiple groups of upper pads on the front side of the substrate corresponding to the multiple groups of metal vias, etching multiple groups of lower pads on the reverse side of the substrate corresponding to the multiple groups of metal vias, and etching electroplating circuits on the substrate to electrically connect all the upper pads with all the lower pads on the substrate through the metal vias;
step 3: electroplating the substrate to fill and seal the metal vias;
step 4: die-bonding a group of RGB LED chips onto any one of the upper pads of each group of upper pads of the multiple groups of upper pads, and welding wires from the RGB LED chips to the other upper pads of the each group of upper pads of the multiple groups of upper pads to form multiple light emitting units on the substrate; and
step 5: cutting the substrate according to the number of the light emitting units as needed to form packaging modules having a plurality of light emitting units and cutting off the electroplating circuits during the cutting so that all the upper pads of each light emitting unit of the plurality of light emitting units are independent from each other and all the lower pads of the each light emitting unit of the plurality of light emitting units are independent from each other.

The method for preparing a surface-mounted RGB LED packaging module, wherein the electroplating circuits are arranged on the front side and/or the reverse side of the substrate.

The method for preparing a surface-mounted RGB LED packaging module, wherein step 4 further comprises: after the multiple light emitting units are formed, preparing a protective layer on the multiple light emitting units.

The method for preparing a surface-mounted RGB LED packaging module, wherein step 4 further comprises: after the multiple light emitting units are formed, preparing an isolating frame around each light emitting unit of the multiple light emitting units.

The method for preparing a surface-mounted RGB LED packaging module, wherein the isolating frame is baked at a temperature of 100-300 degrees Celsius for aging.

The method for preparing a surface-mounted RGB LED packaging module according to the present invention has the beneficial effects that a plurality of light emitting units is integrated into one packaging module, so that the production efficiency of LEDs in subsequent production and application is greatly improved, and the production cost is greatly reduced; at the same time, the plurality of light emitting units is integrated into one module, so compared with the conventional single LED, the LED module provided by the present invention has better sealing performance, and is less susceptible to the erosion of water vapor and longer in service life; in addition, the plurality of light emitting units is integrated into one module, which can effectively improve the overall resistance of a display screen to external mechanical strength, and an isolating frame may be arranged around each of the light emitting units to reduce the influence among the light emitting units, thereby improving the resolution and contrast of the LED display screen. Compared with the existing integrated module, the integration of a plurality of light emitting units into one module has the advantages that one template of the present invention includes fewer light emitting units, which can effectively avoid the problems of color development difference and poor entire screen consistency caused by center value differences of different batches of chips or substrate ink differences; in addition, the existing integrated module is high in maintenance cost if some light emitting units fail, but the present invention is low in maintenance cost.

### Brief Description of the Drawings

Figure 1 is a structure diagram of an existing PPA support.
Figure 2 is a structure diagram of an existing CHIP type packaging support.
Figure 3 is a front view of a 1*2 surface-mounted RGB LED packaging module obtained by a method according to the present invention.
Figure 4 is a front view of a 1*2 surface-mounted RGB LED packaging module with an isolating frame obtained by a method according to the present invention.
Figure 5 is a reverse view of the 1*2 surface-mounted RGB LED packaging module obtained by a method according to the present invention.
Figure 6 is a cross-sectional view of the 1*2 surface-mounted RGB LED packaging module obtained by a method according to the present invention.
Figure 7 is a cross-sectional view of the 1*2 surface-mounted RGB LED packaging module with an isolating frame obtained by a method according to the present invention.
Figure 8a is an electroplating circuit diagram of the 1*2 surface-mounted RGB LED packaging module obtained by a method according to the present invention.
Figure 8b is a cutting circuit diagram of the 1*2 surface-mounted RGB LED packaging module obtained by a method according to the present invention.
Figure 9 is a front view of a 1*3 surface-mounted RGB LED packaging module obtained by a method according to the present invention.
Figure 10 is a reverse view of the 1*3 surface-mounted RGB LED packaging module obtained by a method according to the present invention.
Figure 11a is an electroplating circuit diagram of the 1*3 surface-mounted RGB LED packaging module obtained by a method according to the present invention.
Figure 11b is a cutting circuit diagram of the 1*3 surface-mounted RGB LED packaging module obtained by a method according to the present invention.
Figure 12 is a front view of an L-shaped 1*3 surface-mounted RGB LED packaging module obtained by a method according to the present invention.
Figure 13 is a reverse view of the L-shaped 1*3 surface-mounted RGB LED packaging module obtained by a method according to the present invention.
Figure 14 is a cutting circuit diagram of the L-shaped 1*3 surface-mounted RGB LED packaging module obtained by a method according to the present invention.
Figure 15 is a front view of a 1*4 surface-mounted RGB LED packaging module obtained by a method according to the present invention.
Figure 16 is a reverse view of the 1*4 surface-mounted RGB LED packaging module obtained by a method according to the present invention.
Figure 17a is a reverse electroplating circuit diagram of the 1*4 surface-mounted RGB LED packaging module obtained by a method according to the present invention.
Figure 17b is a reverse cutting circuit diagram of the 1*4 surface-mounted RGB LED packaging module obtained by a method according to the present invention.
Figure 18a is a front electroplating circuit diagram of the 1*4 surface-mounted RGB LED packaging module obtained by a method according to the present invention.
Figure 18b is a front cutting circuit diagram of the 1*4 surface-mounted RGB LED packaging module obtained by a method according to the present invention.
Figure 19 is another reverse electroplating circuit diagram of the 1*4 surface-mounted RGB LED packaging module obtained by a method according to the present invention.
Figure 20 is yet another reverse electroplating circuit diagram of the 1*4 surface-mounted RGB LED packaging module obtained by a method according to the present invention.
Figure 21 is a preparing flow diagram of a surface-mounted RGB LED packaging module obtained by a method according to the present invention; the method for preparing a surface-mounted RGB LED packaging module falling under the claimed invention.

Indication for drawing reference: 1. substrate; 101. identification zone; 2. upper pad; 201. first weld zone; 202. second weld zone; 203. chip weld zone; 204. third weld zone; 3. metal via; 4. RGB LED chip; 401. key and wire; 5. lower pad; 6. electroplating circuit; 7. cutting line; 8. protective layer; 9. isolating frame.

### Detailed Description of the Invention

For the purpose of making objectives, technical schemes and advantages of the present invention clearer, the following further describes the present invention in detail with reference to the accompanying drawings and embodiments.

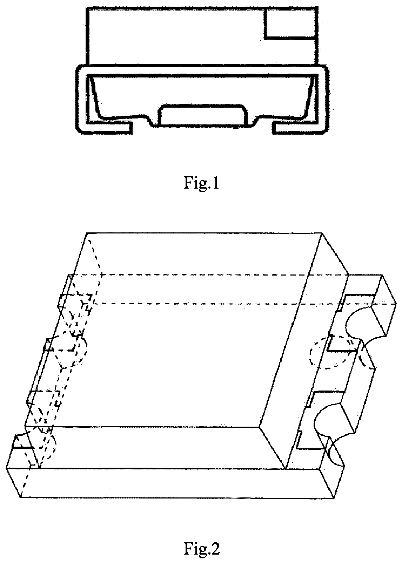

Figure 1 is a structure diagram of an existing PPA+ copper pin packaging support, Figure 2 is a structure diagram of an existing CHIP type packaging support, and both are of single packaging structures. In actual production, with the reduction of pixel pitches of LED display screens, more and more packaging devices are on per unit area, so the number of LED packaging devices used is huge in actual use, so the production efficiency is extremely low by the single-mount production method.

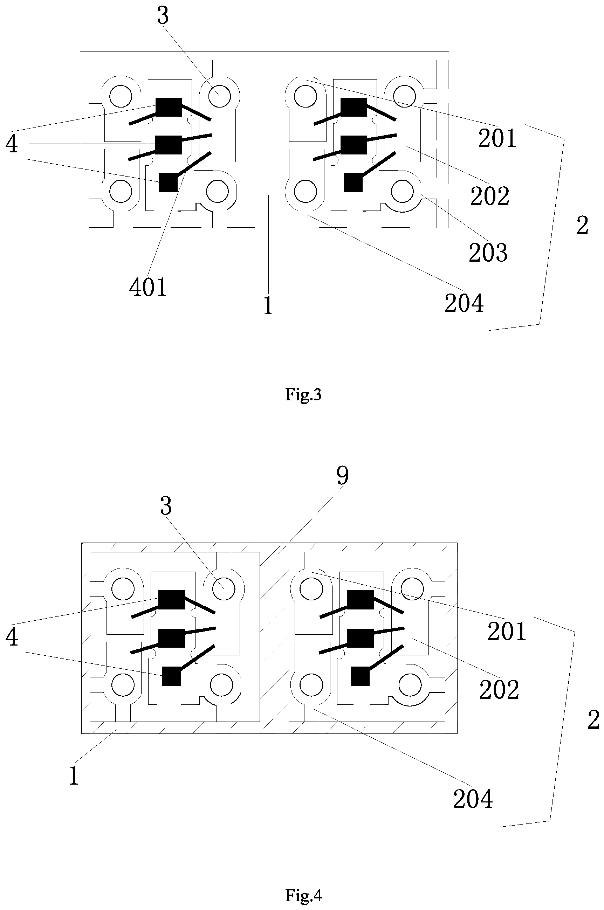

Referring to Figure 3 to Figure 20, embodiments of a surface-mounted RGB LED packaging module obtained by a method according to the present invention are provided. The surface-mounted RGB LED packaging module obtained by a method according to the present invention includes a substrate 1 and light emitting units arranged on the substrate 1, a protective layer 8 is arranged on the light emitting units, the number of the light emitting units is at least two, each light emitting unit includes four mutually independent upper pads 2 and a group of RGB LED chips 4, the RGB LED chips 4 are arranged on any one of the upper pads 2 and connected with the other three upper pads 2 by keys and wires 401, each upper pad 2 is provided with metal vias 3 that penetrate the substrate 1 and are conductive up and down, lower pads 5 are arranged on the reverse side of the substrate 1 corresponding to the metal vias 3, and the lower pads 5 are independent from each other. Compared with the conventional single LED package, the packaging module according to the present invention includes a plurality of light emitting units arranged on the substrate 1, and LED beads are mounted later in the form of a module, so the mounting efficiency of the present invention is extremely high compared with the single mounting method, and the mounting efficiency is improved as the number of the light emitting units of the packaging module increases. If the number of the light emitting units of the packaging module is 16, the mounting efficiency can be increased by 16 times. Preferably, the number of the light emitting units of the present invention is 2-16. The light emitting units may also be arranged in an inverted "L" shape. The arrangement of the light emitting units is not limited in the present invention and may be a transverse-shape "-" arrangement, or a combination of rows and columns of M×N (M and N are integers), or other irregular arrangement, and the present invention is not limited thereto. It should be noted that modifications or changes could be made by those of ordinary skill in the art according to the above description, and all these modifications and changes shall fall within the scope of the present invention defined by the appended claims.

In a practical application, isolating frames 9 are arranged around each of the light emitting units to reduce the influence among the light emitting units, thereby improving the resolution and contrast of an LED display screen. Preferably, the isolating frames 9 are lighttight frames, which further prevents light from penetrating the isolating frames 9. Further, the isolating frames 9 are black.

In a practical application, the surface of the protective layer 8 is rough and non-reflective. Preferably, the protective layer 8 is a translucent epoxy resin glue layer with a diffusing agent. The arrangement of the protective layer 8 is capable of preventing the ingress of water vapor and preventing mechanical damage of components. The translucent epoxy resin glue with the diffusing agent is used as the protective layer 8 in the present invention, so that light penetrates the protective layer 8 more uniformly, and the influence of the protective layer 8 on the light is reduced.

In a practical application, as shown in Figure 3, the four independent upper pads are respectively an "L"-shaped chip weld zone 203 in the middle for holding the RGB LED chips 4, as well as a first weld zone 201, a second weld zone 202 and a third weld zone 204 at the upper left corner, the upper right corner and the lower left corner respectively. Preferably, the chip weld zone 203 serves as a common pole zone. The RGB LED chips 4 are fixed on the chip weld zone 203 in the center by means of die-bonding glue, so that the light can be more concentrated.

In actual production, both the upper pads 2 and the lower pads 5 are welded after electroplating. Since the upper pads 2 and the lower pads 5 are independent from each other, all the upper pads 2 and the lower pads 5 need to be electrically connected before electroplating. Electroplating circuits are provided in the present invention to connect all the pads. When it is cut into single products, the electroplating circuits are cut off to keep the respective pads independent. However, the package obtained by a method according to the present invention is not a single package but is a packaging module including a plurality of light emitting units. Thus, when the electroplating circuits are provided, all the pads are not simply connected. When the products are cut, it is necessary to cut off all the electroplating circuits while the packaging modules having a plurality of light emitting units are cut.

The following specifically describes the present invention in conjunction with several embodiments of the present invention:

### Embodiment 1

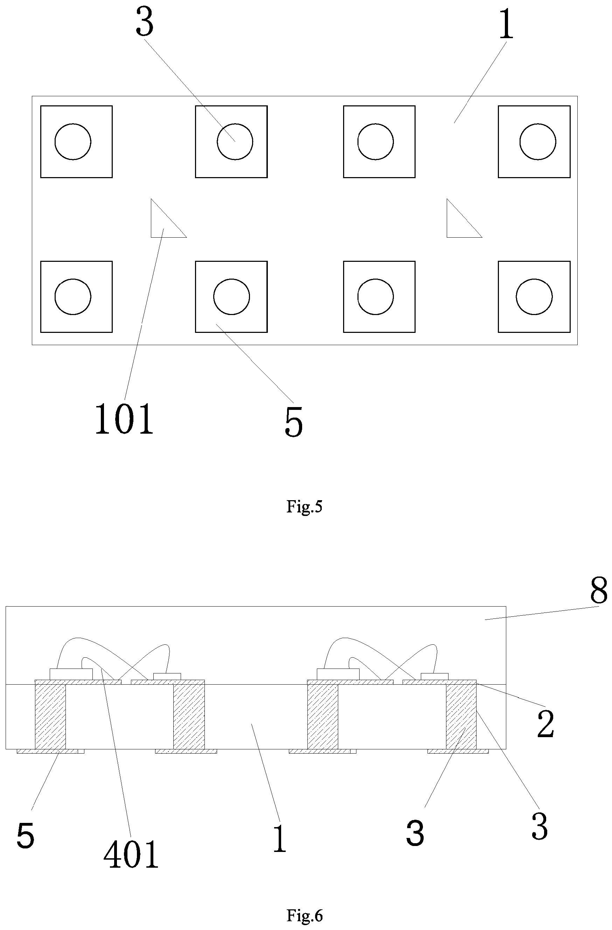

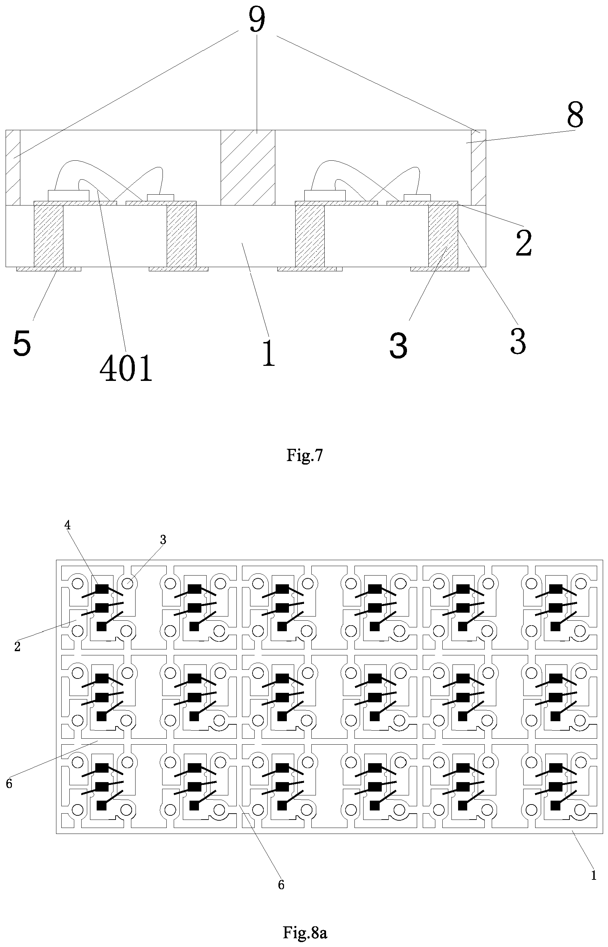

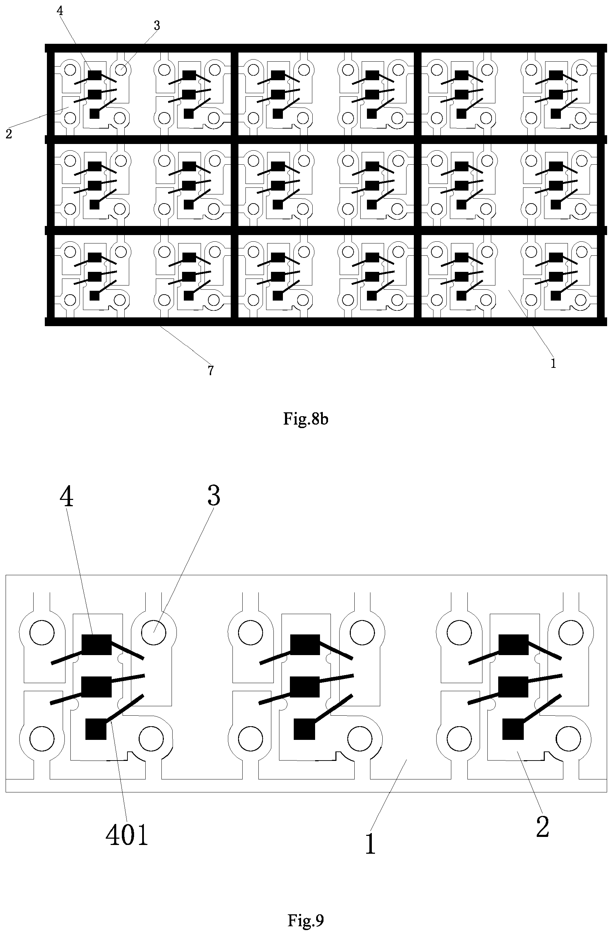

Referring to Figures 3-8, a 1*2 surface-mounted RGB LED packaging module obtained by a method according to the present invention is provided. The packaging module has two light emitting units. In actual production, as shown in Figure 4 and Figure 7, isolating frames 9 are arranged around each of the light emitting units to reduce the influence between the light emitting units. Preferably, as shown in Figure 5, on the reverse side of the substrate 1, identification zones 101 are arranged in the middle of each light emitting unit to facilitate subsequent test and help a packaging apparatus identify the front and reverse sides of the packaging module. As shown in Figure 6 and Figure 7, a protective layer 8 is arranged on the light emitting units. The protective layer 8 is preferably a translucent epoxy resin glue layer with a diffusing agent. The arrangement of the protective layer 8 is capable of preventing the ingress of water vapor and preventing mechanical damage of components. Preferably, the protective layer 8 is formed by die pressing or glue injection. Referring to Figure 8a and Figure 8b, in actual production, a plurality of light emitting units is first arranged on the substrate 1, and then packaging modules having a specified number of lights emitting units are cut. Figure 8a is an electroplating circuit diagram of packaging modules having two light emitting units, and Figure 8b is a corresponding cutting circuit diagram. The cutting process is performed along cutting lines 7. In a practical application, the cutting lines 7 do not need to be actually drawn, only a program is set, and the cutting apparatus performs cutting according to the set cutting direction. In actual production, the blade edge of the cutting tool is wider than electroplating circuits 6 to ensure that the electroplating circuits 6 are completely cut off. The electroplating circuits 6 may be arranged on the front side of the substrate 1, or on the reverse side of the substrate 1, or on the front and reverse sides of the substrate 1. In the presence of the metal vias 3, the upper pads 2 and the lower pads 5 at the corresponding positions are mutually conductive, so all the pads can be electrically connected as long as all the upper pads 2 or all the lower pads 5 are connected. As shown in Figures 8a and 8b, in the present embodiment, the electroplating circuits 6 are arranged on the front side of the substrate 1, buses of the electroplating circuits 6 are arranged on the cutting lines 7, and all the upper pads 2 are connected to the buses of the nearest electroplating circuits 6 through the electroplating circuits 6 to ensure that all the electroplating circuits 6 are cut off during the cutting process, and all the upper pads 2 are independent from each other. The electroplating circuits 6 in Figure 8a are only one of the circuit connection modes, those skilled in the art can easily conceive of other connection modes according to the present invention, and the present invention is not limited thereto. All the connection modes improved or transformed from the above description shall fall within the scope of the present invention defined by the appended claims.

### Embodiment 2:

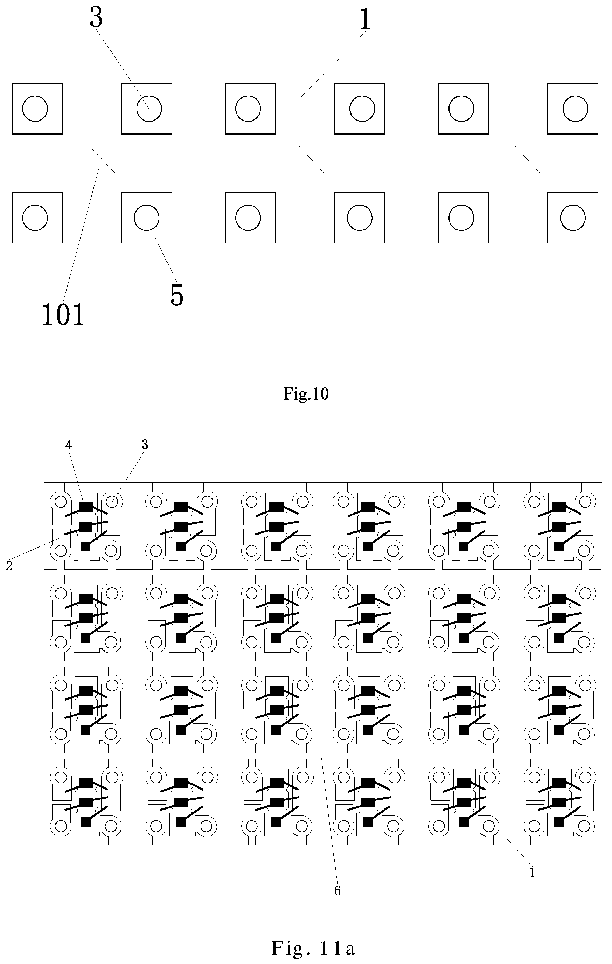

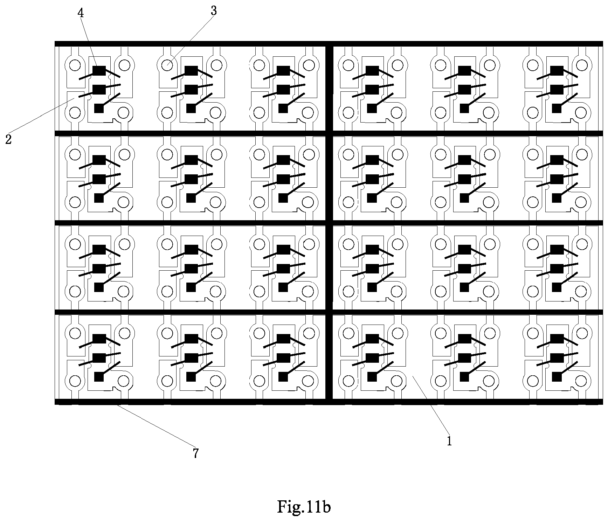

Referring to Figure 9 to Figure 11, a 1*3 surface-mounted RGB LED packaging module obtained by a method according to the present invention has three light emitting units. The structure of the light emitting units is the same as that of the light emitting units in Embodiment 1. As shown in Figures 11a and 11b, 24 light emitting units are arranged on the substrate 1 and distributed in 4 rows and 6 columns. As shown in Figure 11b, the substrate 1 is divided into 8 packaging modules by cutting lines 7, electroplating circuits 6 are also arranged on the positions of the cutting lines 7, and all the electroplating circuits 6 of the present embodiment are arranged on the front side of the substrate 1. All the upper pads 2 are connected to the nearest electroplating circuits 6 at the positions of the cutting lines 7 through the electroplating circuits 6. When the substrate 1 is cut, all the electroplating circuits 6 at the positions of the cutting lines 7 are cut off, and all the upper pads 2 are thus independent from each other and are no longer connected by the electroplating circuits 6.

### Embodiment 3:

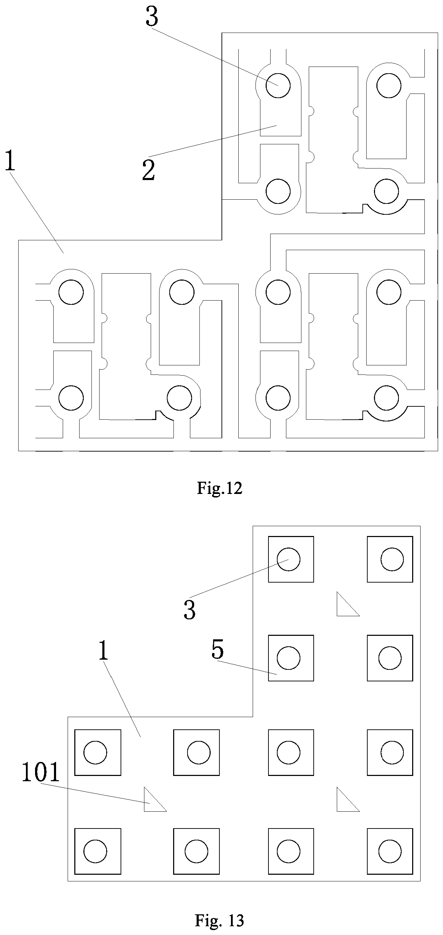

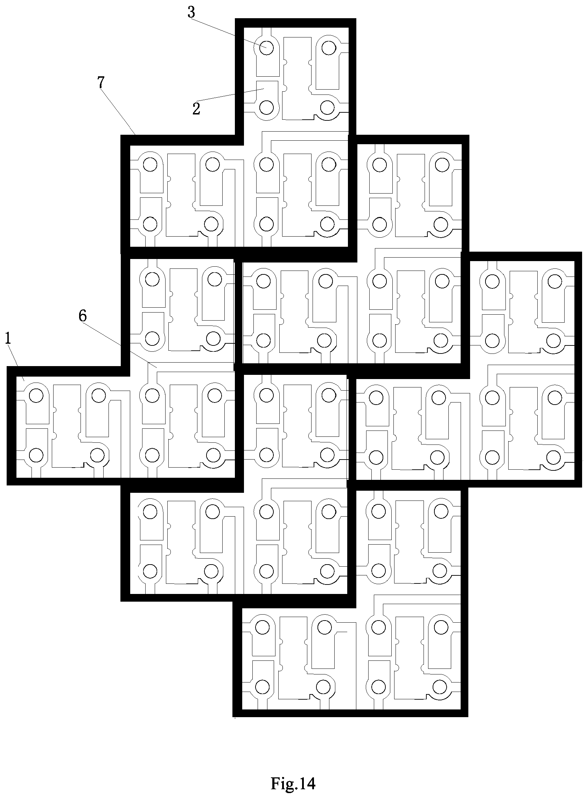

Figure 12 to Figure 14 show another 1*3 surface-mounted RGB LED packaging module obtained by a method according to the present invention. All the packaging modules also have three light emitting units, but the arrangement of the light emitting units is different from that in the Embodiment 2. In the present embodiment, the three light emitting units are arranged in an inverted "L" shape, and the arrangement of the light emitting units is not limited in the present invention. As shown in Figure 14, the electroplating circuits of the present embodiment are arranged on the front side of the substrate 1, the electroplating circuits 6 are also at the positions of the cutting lines 7, all the upper pads 2 are electrically connected to the electroplating circuits 6 at the positions of the cutting lines 7, and the specific connection mode is not limited in the present embodiment.

### Embodiment 4:

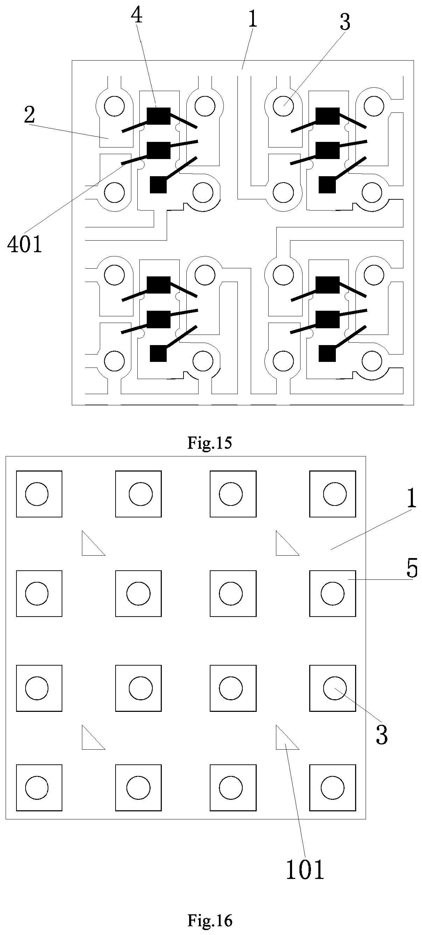

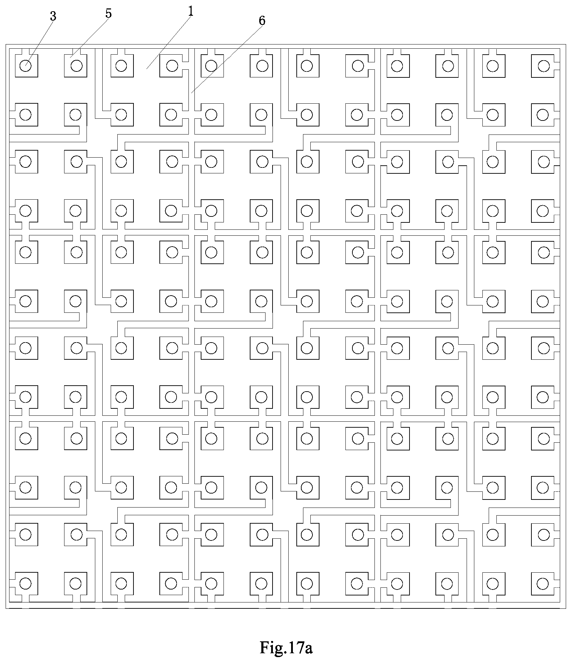

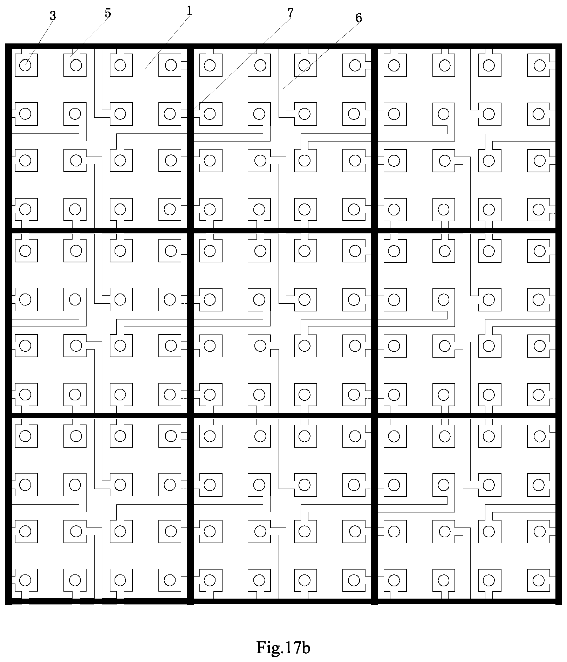

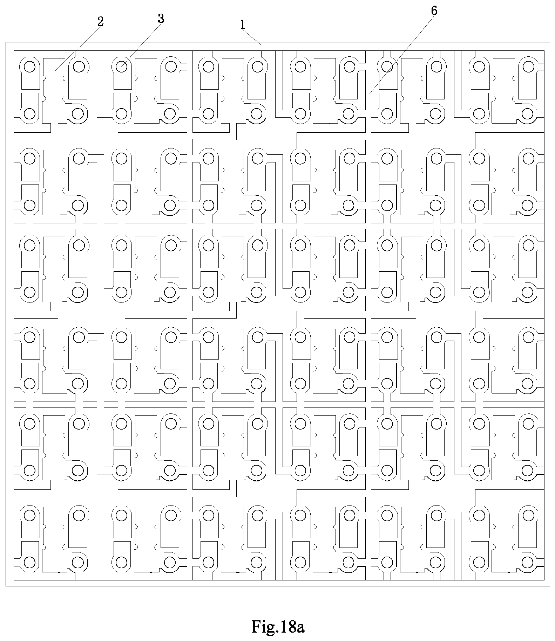

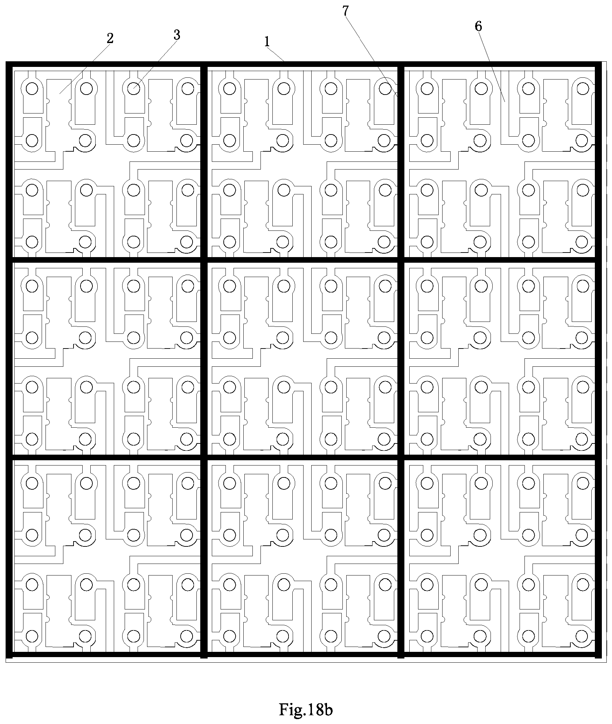

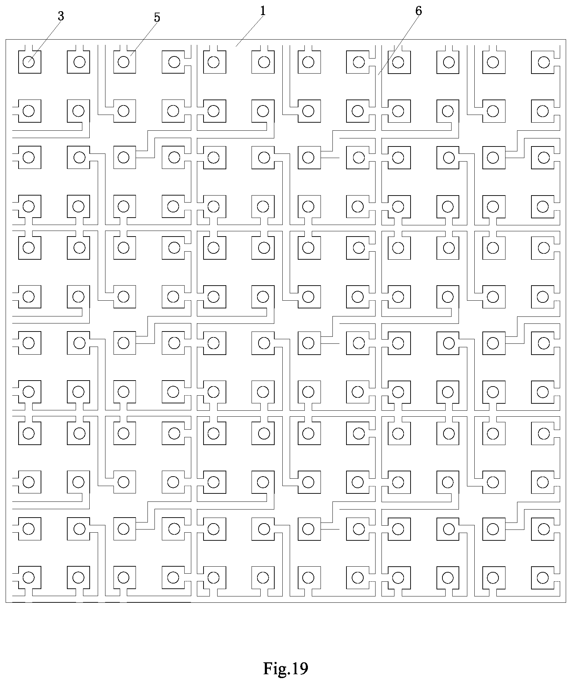

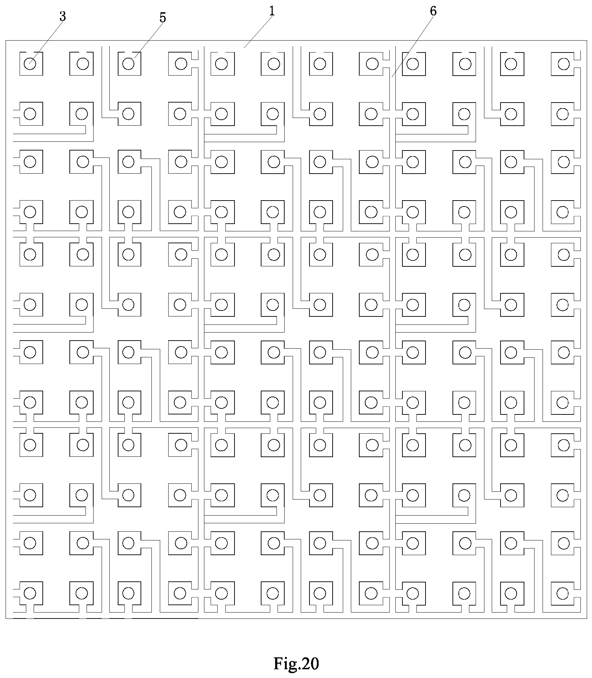

Figures 15 to 20 show 1*4 surface-mounted RGB LED packaging modules obtained by a method according to the present invention, wherein the packaging module has four light emitting units. As shown in Figure 15, the light emitting units are arranged in a square shape, or arranged in a line in other embodiments of the present invention, and the electroplating circuits 6 are connected in the same way as in Embodiments 1 and 2. For the connection mode of the electroplating circuits 6, the electroplating circuits 6 can be arranged on the reverse side of the substrate 1 (as shown in Figure 17a), or on the front side of the substrate 1 (as shown in Figure 18a), or on the front and reverse sides. For a specific connection mode, all the pads may be connected to the positions of the cutting lines 7 as in Embodiment 1-3, or as shown in Figure 19 or Figure 20. It can be seen that the connection mode of the electroplating circuits 6 is varied, other modifications can be easily obtained by those skilled in the art based on the description of the present invention, and all these improvements and modifications fall within the scope of the present invention defined by the appended claims.

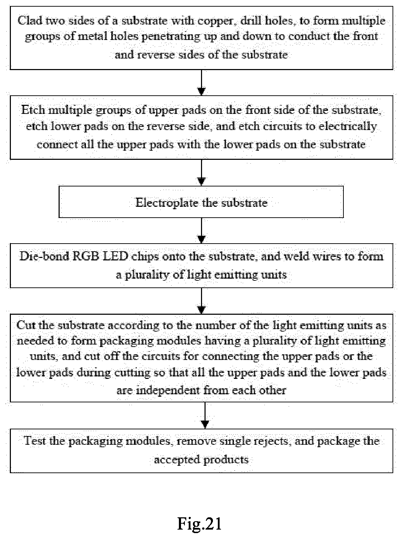

Referring to Figure 21, the present invention provides a preparing method of a surface-mounted RGB LED packaging module, including the following steps:
Step 1: cladding two sides of a plate with copper to form a substrate 1, drilling holes through the substrate 1, and forming multiple groups of metal vias 3 penetrating up and down the substrate 1 to electrically connect the front and reverse sides of the substrate 1. In practical applications, a BT copper clad plate, an FR4 copper clad plate or other circuit board can be directly used as the substrate 1.
Step 2: etching multiple groups of upper pads 2 on the front side of the substrate 1 corresponding to the multiple groups of metal vias 3, etching multiple groups of lower pads 5 on the reverse side of the substrate 1 corresponding to the multiple groups of metal vias 3, and etching electroplating circuits 6 on the substrate 1 to electrically connect all the upper pads 2 with all the lower pads 5 on the substrate 1 through the metal vias. As described above, the electroplating circuits 6 play a role in electrically connecting all the upper pads 2 with the lower pads 5 for electroplating use in subsequent processes, and the connection mode of the electroplating circuits 6 is not limited.
Step 3: electroplating the substrate 1 to fill and seal the metal vias 3. Preferably, during the electroplating process, the metal vias 3 are filled and sealed to ensure that the glue does not penetrate to the lower pads 5 through the metal vias 3 during the subsequent process of preparing a protective layer 8.
Step 4: die-bonding a group of RGB LED chips 4 onto any one of the upper pads 2 of each group of upper pads 2 of the multiple groups of upper pads 2 by a die-bonding glue, and welding wires 401 from the RGB LED chips 4 to the other upper pads 2 of the each group of upper pads 2 of the multiple groups of upper pads 2 to form multiple light emitting units on the substrate 1. Preferably, physical electrical connection is performed by means of keys and wires.
Step 5: cutting the substrate 1 according to the number of the light emitting units as needed to form packaging modules having a plurality of light emitting units and cutting off the electroplating circuits 6 during the cutting so that all the upper pads 2 of each light emitting unit of the plurality of light emitting units are independent from each other and all the lower pads 5 of the each light emitting unit of the plurality of light emitting units are independent from each other.

In practical applications, the electroplating circuits 6 are arranged on the front side and/or the reverse side of the substrate 1. Preferably, the electroplating circuits 6 are arranged on the reverse side of the substrate 1 to facilitate cutting.

In a practical application, step 4 further includes: after the multiple light emitting units are formed, preparing the protective layer 8 on the multiple light emitting units.

In a practical application, step 4 further includes: after the multiple light emitting units are formed, preparing an isolating frame 9 around each light emitting unit of the multiple light emitting units. Preferably, the isolating frame 9 is baked and aged to further strengthen the mechanical strength thereof. Preferably, the baking temperature is 100 to 300 degrees Celsius.

The method for preparing a surface-mounted RGB LED packaging module according to the present invention has the advantages that a plurality of light emitting units is integrated into one packaging module, so that the production efficiency of LEDs in subsequent production and application is greatly improved, and the production cost is greatly reduced; at the same time, the plurality of light emitting units is integrated into one module, so compared with the conventional single LED, the LED module provided by the present invention has better sealing performance, and is less susceptible to the erosion of water vapor and longer in service life; and an isolating frame may be arranged around each of the light emitting units to reduce the influence among the light emitting units, thereby improving the resolution and contrast of an LED display screen.

It should be understood that the application of the present invention is not limited to the above examples, modifications or changes may be made by those of ordinary skill in the art according to the above description, and all these modifications and changes shall fall within the scope of the present invention defined by the appended claims.

## Claims

1. A method for preparing a surface-mounted RGB-LED packaging module, comprising the following steps:
step 1: cladding two sides of a plate with copper to form a substrate (1), drilling holes through the substrate (1), and forming multiple groups of metal vias (3) penetrating up and down the substrate (1) to electrically connect the front and reverse sides of the substrate (1);
step 2: etching multiple groups of upper pads (2) on the front side of the substrate (1) corresponding to the multiple groups of metal vias (3), etching multiple groups of lower pads (5) on the reverse side of the substrate (1) corresponding to the multiple groups of metal vias (3), and etching electroplating circuits (6) on the substrate (1) to electrically connect all the upper pads (2) with all the lower pads (5) on the substrate (1) through the metal vias (3);
step 3: electroplating the substrate (1) to fill and seal the metal vias (3);
step 4: die-bonding a group of RGB LED chips (4) onto any one of the upper pads (2) of each group of upper pads (2) of the multiple groups of upper pads (2), and welding wires (401) from the RGB LED chips (4) to the other upper pa(2) of the each group of upper pads (2) of the multiple groups of upper pads (2) to form multiple light emitting units on the substrate (1); and
step 5: cutting the substrate (1) according to the number of the light emitting units as needed to form packaging modules having a plurality of light emitting units and cutting off the electroplating circuits (6) during the cutting so that all the upper pads (2) of each light emitting unit of the plurality of light emitting units are independent from each other and all the lower pads (5) of the each light emitting unit of the plurality of light emitting units are independent from each other.

2. The method for preparing a surface-mounted RGB-LED packaging module according to claim 1, wherein the electroplating circuits (6) are arranged on the front side and/or the reverse side of the substrate (1).

3. The method for preparing a surface-mounted RGB-LED packaging module according to claim 1, wherein step 4 further comprises: after the multiple light emitting units are formed, preparing a protective layer (8) on the multiple light emitting units

4. The method for preparing a surface-mounted RGB-LED packaging module according to claim 1, wherein step 4 further comprises: after the multiple light emitting units are formed, preparing an isolating frame (9) around each light emitting unit of the multiple light emitting units.

5. The method for preparing a surface-mounted RGB-LED packaging module according to claim 4, wherein the isolating frame (9) is baked at a temperature of 100-300 degrees Celsius for aging.

## Patentansprüche

1. - Verfahren zum Herstellen eines oberflächenmontierten RGB-LED-Verpackungsmoduls, umfassend die folgenden Schritte:
Schritt 1: Beschichten von zwei Seiten einer Platte mit Kupfer, um ein Substrat (1) zu bilden, Bohren von Löchern durch das Substrat (1) und Bilden mehrerer Gruppen von metallischen Durchkontaktierungen (3), die das Substrat (1) nach oben und unten durchdringen, um die Vorder- und Rückseite des Substrats (1) elektrisch zu verbinden;
Schritt 2: Ätzen mehrerer Gruppen von oberen Lötaugen (2) auf der Vorderseite des Substrats (1), die den mehreren Gruppen von metallischen Durchkontaktierungen (3) entsprechen, und Ätzen mehrerer Gruppen von unteren Lötaugen (5) auf der Rückseite des Substrats (1), die den mehreren Gruppen von metallischen Durchkontaktierungen (3) entsprechen, und Ätzen von Elektroplattierungsschaltungen (6) auf dem Substrat (1), um alle oberen Lötaugen (2) durch die metallischen Durchkontaktierungen (3) elektrisch mit den unteren Lötaugen (5) auf dem Substrat (1) zu verbinden;
Schritt 3: Elektroplattieren des Substrats (1) zum Füllen und Versiegeln der metallischen Durchkontaktierungen (3);
Schritt 4: Die-Bonden einer Gruppe von RGB-LED-Chips (4) auf eines der oberen Lötaugen (2) jeder Gruppe von oberen Lötaugen (2) der mehreren Gruppen von oberen Lötaugen (2), und Schweißen von Drähten (401) von den RGB-LED-Chips (4) zu den anderen oberen Lötaugen (2) jeder Gruppe von oberen Lötaugen (2) der mehreren Gruppen von oberen Lötaugen (2), um mehrere lichtemittierende Einheiten auf dem Substrat (1) zu bilden; und
Schritt 5: Schneiden des Substrats (1) entsprechend der Anzahl der lichtemittierenden Einheiten, wie es zur Bildung von Verpackungsmodulen mit einer Vielzahl von lichtemittierenden Einheiten erforderlich ist, und Abschneiden der Elektroplattierungsschaltungen (6) während des Schneidens, sodass alle oberen Lötaugen (2) von jeder lichtemittierenden Einheit der Vielzahl von lichtemittierenden Einheiten unabhängig voneinander sind und alle unteren Lötaugen (5) von jeder lichtemittierenden Einheit der Vielzahl von lichtemittierenden Einheiten unabhängig voneinander sind.

2. - Verfahren zum Herstellen eines oberflächenmontierten RGB-LED-Verpackungsmoduls nach Anspruch 1, wobei die Elektroplattierungsschaltungen (6) auf der Vorderseite und/oder der Rückseite des Substrats (1) angeordnet sind.

3. - Verfahren zum Herstellen eines oberflächenmontierten RGB-LED-Verpackungsmoduls nach Anspruch 1, wobei Schritt 4 ferner Folgendes umfasst: nachdem die mehreren lichtemittierenden Einheiten gebildet wurden, Herstellen einer Schutzschicht (8) auf den mehreren lichtemittierenden Einheiten.

4. - Verfahren zum Herstellen eines oberflächenmontierten RGB-LED-Verpackungsmoduls nach Anspruch 1, wobei Schritt 4 ferner Folgendes umfasst: nachdem die mehreren lichtemittierenden Einheiten gebildet wurden, Herstellen eines Isolierrahmens (9) um jede lichtemittierende Einheit der mehreren lichtemittierenden Einheiten.

5. - Verfahren zum Herstellen eines oberflächenmontierten RGB-LED-Verpackungsmoduls nach Anspruch 4, wobei der Isolierrahmen (9) zur Alterung bei einer Temperatur von 100-300 Grad Celsius eingebrannt wird.

## Revendications

1. - Procédé pour préparer un module d'encapsulation de DEL RVB monté en surface, comprenant les étapes suivantes :
étape 1 : revêtir deux côtés d'une plaque avec du cuivre pour former un substrat (1), percer des trous à travers le substrat (1), et former de multiples groupes de vias métalliques (3) pénétrant vers le haut et vers le bas le substrat (1) pour relier électriquement les côtés avant et arrière du substrat (1) ;
étape 2 : graver plusieurs groupes de pastilles supérieures (2) sur le côté avant du substrat (1) correspondant aux multiples groupes de vias métalliques (3), graver de multiples groupes de pastilles inférieures (5) sur le côté arrière du substrat (1) correspondant aux multiples groupes de vias métalliques (3), et graver des circuits d'électrodéposition (6) sur le substrat (1) pour relier électriquement toutes les pastilles supérieures (2) avec toutes les pastilles inférieures (5) sur le substrat (1) par l'intermédiaire des vias métalliques (3) ;
étape 3 : effectuer une électrodéposition sur le substrat (1) pour remplir et sceller les vias métalliques (3) ;
étape 4 : effectuer une fixation de puces d'un groupe de puces de DEL RVB (4) sur l'une quelconque des pastilles supérieures (2) de chaque groupe de pastilles supérieures (2) des multiples groupes de pastilles supérieures (2), et souder des fils (401) des puces de DEL RVB (4) aux autres pastilles supérieures (2) de chaque groupe de pastilles supérieures (2) des multiples groupes de pastilles supérieures (2) pour former de multiples unités électroluminescentes sur le substrat (1) ; et
étape 5 : découper le substrat (1) en fonction du nombre d'unités électroluminescentes nécessaires pour former des modules d'encapsulation ayant une pluralité d'unités électroluminescentes, et couper les circuits d'électrodéposition (6) pendant la découpe de telle sorte que toutes les pastilles supérieures (2) de chaque unité électroluminescente de la pluralité d'unités électroluminescentes sont indépendantes les unes des autres et que toutes les pastilles inférieures (5) de chaque unité électroluminescente de la pluralité d'unités électroluminescentes sont indépendantes les unes des autres.

2. - Procédé de préparation d'un module d'encapsulation de DEL RVB monté en surface selon la revendication 1, dans lequel les circuits d'électrodéposition (6) sont disposés sur le côté avant et/ou le côté arrière du substrat (1).

3. - Procédé de préparation d'un module d'encapsulation de DEL RVB monté en surface selon la revendication 1, dans lequel l'étape 4 comprend en outre : après la formation des multiples unités électroluminescentes, préparer une couche protectrice (8) sur les multiples unités électroluminescentes.

4. - Procédé de préparation d'un module d'encapsulation de DEL RVB monté en surface selon la revendication 1, dans lequel l'étape 4 comprend en outre : après la formation des multiples unités électroluminescentes, préparer un cadre isolant (9) autour de chaque unité électroluminescente des multiples unités électroluminescentes.

5. - Procédé de préparation d'un module d'encapsulation de DEL RVB monté en surface selon la revendication 4, dans lequel le cadre isolant (9) est cuit à une température de 100 - 300 degrés Celsius pour le vieillissement.
